# DEMANDE DE BREVET EUROPEEN

(11) **EP 0 923 278 A1**
(43) Date de publication de la demande: **16.06.1999**
(21) Numéro de dépôt: 98500259.1
(22) Date de dépôt: 01.12.1998
(51) Int. Cl.: H05K 3/20, H05K 3/06, H05K 3/00

(54) **Procédé de fabrication de circuits imprimés**

(30) Priorité: 05.12.1997 ES 9702533
(71) Demandeur: MECANISMOS AUXILIARES INDUSTRIALES S.A. M.A.I.S.A., E-43800 Valls, Tarragona (ES)
(72) Inventeur: Kroebel Nieto, Rodolfo, 43800 Valls (Tarragona) (ES)
(74) Mandataire: Morgades Manonelles, Juan Antonio

(57) **Abrégé**

Le procédé commencera comme il est décrit dans le brevet principal, avec l'usinage d'une feuille de cuivre (10) à sa base supérieure (11), de telle manière qu'à travers les procédés de coupe ou de fraisage chimique, il s'y créera des sillons (13) ou entrepistes; cela s'effectuera en double, c'est-à-dire, en utilisant deux feuilles de cuivre (10) qui, une fois usinées selon les formes décrites et à l'aide des moyens adéquats, seront immobilisées pour produire le diélectrique (14) entre celles-ci, à partir d'un moulage ou d'injection ou d'une méthode similaire, grâce à quoi on évitera la double production de substrat diélectrique et le collage postérieur de celui-ci.

## Description

La présente demande de brevet additionnel consiste, comme son énoncé l'indique, en des "AMELIORATIONS INTRODUITES DANS LE PROCEDE DE FABRICATION DE CIRCUITS IMPRIMES OBJET DU BREVET PRINCIPAL Nº 9700184 (8) PAR UN PROCEDE DE FABRICATION DE CIRCUITS IMPRIMES", dont les nouvelles caractéristiques de construction, conformation et conception remplissent, avec un maximum de sécurité et d'efficacité, la mission pour laquelle elles ont été spécifiquement projetées.

Dans le brevet principal nº 9700184 (8) du même titulaire, on décrivait et revendiquait un nouveau procédé de fabrication de circuits imprimés, consistant essentiellement en la disposition d'une feuille de cuivre sur laquelle, au moyen de coupe par fraisage chimique, on produisait des sillons ou entrepistes pour ensuite, à l'aide des moyens adéquats, procéder à l'injection ou moulage d'une substance ou d'un matériel de type plastique, totalement diélectrique et résistant aux hautes températures et pour enfin, procéder de nouveau à un fraisage ou coupe chimique sur la face opposée de la feuille de cuivre, avec formation des pistes définitives, présentant une section pratiquement rectangulaire, grâce à quoi on évitait la perte de matériel ou de volume que la formation de ces pistes par les méthodes classiques impliquait, parce que, au lieu d'obtenir des plans verticaux dans les entrepistes, il se formait en réalité des plans inclinés provoquant les inconvénients mentionnés.

Avec le procédé précédemment décrit, une série d'avantages était mise en évidence, soit en cas d'application à des circuits d'une seule face, soit qu'on profite de celui-ci pour former des circuits à double face, en pouvant procéder, à travers la disposition d'un adhésif aux caractéristiques spéciales, au collage par la face diélectrique et former ainsi un circuit à double face.

Les améliorations objet de la présente demande consistent essentiellement en l'application au procédé de fabrication de circuits imprimés décrit dans le brevet principal et aux circuits à double face obtenus à partir de ce procédé, où une partie des phases antérieurement décrites sera utilisée, avec seulement la variation de l'une d'entre elles.

Le procédé commencera, comme il est décrit dans le brevet principal, avec l'usinage d'une feuille de cuivre à sa base supérieure, de telle manière qu'à travers les procédés de coupe ou de fraisage chimique, il s'y créera des sillons ou entrepistes; cela s'effectuera en double, c'est-à-dire, en utilizant deux feuilles de cuivre qui, une fois usinées selon les formes décrites et à l'aide des moyens adéquats, seront immobilisées pour produire le diélectrique entre celles-ci, à partir d'un moulage ou d'injection ou d'une méthode similaire, grâce à quoi on évitera la double production de substrat diélectrique et le collage postérieur de celui-ci.

D'autres détails et diverses caractéristiques de cette demande de brevet additionnel apparaîtront au cours de la description que l'on en donne ci-dessous, dans laquelle il est fait référence aux dessins qui accompagnent ce mémoire, où d'une manière un peu schématique, les détails retenus sont représentés. Ces détails sont donnés à titre d'exemple, en référence à un cas possible de réalisation pratique, mais l'invention n'est pas limitée aux détails qui sont ici exposés; cette description doit donc être envisagée d'un seul point de vue explicatif et sans limitations d'aucune sorte.

Voici maintenant une liste détaillée des différents éléments qui sont cités dans la présente demande de brevet d'invention, (10) feuille de cuivre, (11) base supérieure de (10), (12) base inférieure de (10), (13) sillons ou entrepistes, (14) substrat diélectrique, (15) piste, (16) substrat diélectrique classique, (17) arête, (18) volume.

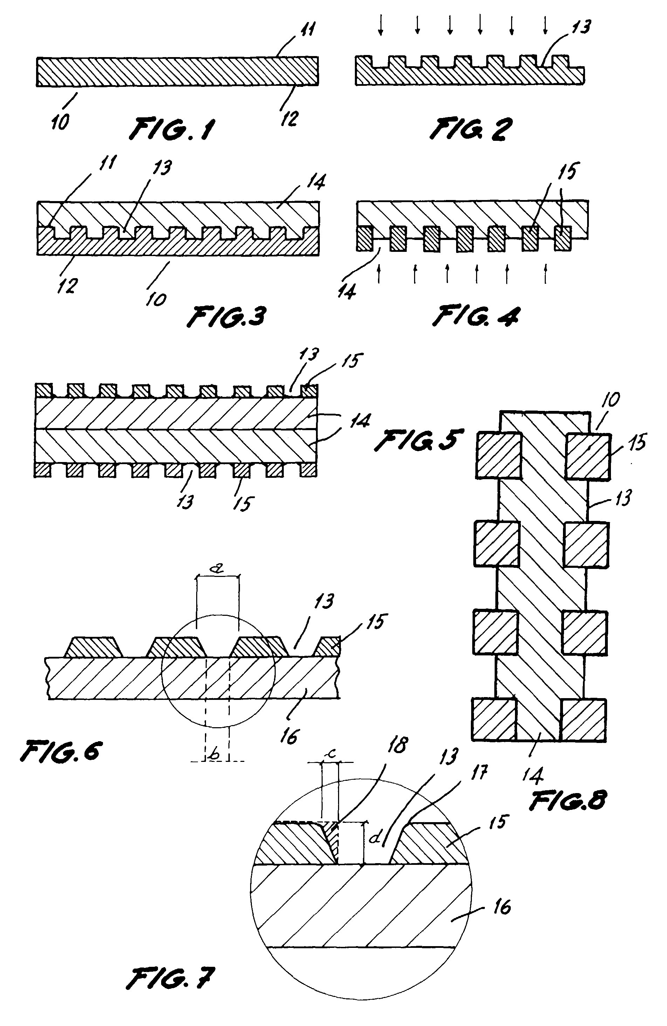

La figure nº 1 est une section transversale en projection verticale d'une feuille de cuivre (10), du type de celles qu'on utilise pour la fabrication de circuits imprimés, sa base supérieure ou endroit étant indiquée par le numéro (11) et la base supérieure ou envers de (10) par le numéro (12).

La figure nº 2 montre la plaque (10) représentée sur la figure nº 1, après qu'on y ait effectué un fraisage chimique, également appelé dans certaines publications coupe chimique; sur les lignes ou les points marqués par les flèches, il se crée des entrepistes ou sillons (13) à la base supérieure (11) du circuit ou feuille (10).

La figure nº 3 correspond à une section transversale en projection verticale, où l'on peut voir comment, après l'apparition des pistes et des entrepistes (13) sur la face (11), d'après la figure nº 2, on réalise une injection ou un moulage par l'intermédiaire d'une substance de type plastique ou similaire, aux caractéristiques totalement diélectriques et résistantes.

La figure nº 4 est une section transversale en projection verticale de la feuille (10), sur laquelle, après l'avoir retournée, on procède à une attaque chimique, fraisage ou coupe chimiques des sillons (13) qui doivent coïncider avec ceux de la figure nº 2 sur la face (12), les pistes (15) se trouvant ainsi formées.

La figure nº 5 représente une exécution dans laquelle, par température ou à l'aide d'un adhésif, on a assemblé deux réalisations, d'après la figure nº 4.

La figure nº 6 est une représentation selon l'Etat de la Technique, de la façon dont se présentent les sillons (13), quand on procède à leur formation à l'aide des attaques chimiques classiques.

La figure nº 7 est un agrandissement de la figure nº 6 dans le voisinage immédiat d'un sillon ou entrepiste (13).

La figure nº 8 est une section transversale en projection verticale d'un circuit imprimé (10) à double face, fabriqué à partir des améliorations introduites dans ce brevet additionnel.

Dans l'une des réalisations retenues qui font l'objet de cette demande et comme on peut le voir sur la figure nº 8, le procédé débute comme il est représenté sur la figure nº1, avec la préparation d'une feuille de cuivre (10), aux mesures et aux dimensions adéquates, avec base supérieure (11) et base inférieure (12), en procédant ensuite, voir la figure nº 2, à une coupe ou un fraisage chimiques à la base supérieure et à la création des sillons (13).

Cette opération se répète au cas où l'on voudrait fabriquer un circuit imprimé à double face avec une autre feuille de cuivre (10), en effectuant les mêmes opérations que celles décrites jusqu'à présent.

Ensuite, à l'aide des moyens adéquats, on immobilise les deux feuilles de cuivre, sur lesquelles les sillons (13) ont déjà été créés et on les place de telle manière que les bases inférieures (12) soient parallèles et dûment séparées, pour effectuer alors, moyennant un moulage ou une injection, l'introduction d'un support diélectrique qui, contrairement à ce qui est décrit dans le brevet principal, se fera en un seul moment, sans qu'il soit besoin de solidariser les deux supports diélectriques (14).

Les figures n^{os} 1 à 7 sont celles qui appartiennent au brevet principal, parce qu'on a préféré ne pas modifier leur contenu et respecter la numération des éléments qui y ont été décrits, pour une plus grande clarté dans l'explication du présent brevet additionnel.

Après avoir suffisamment décrit en quoi consiste cette demande de brevet additionnel en référence aux plans ci-joints, il est facile de voir que l'on pourra y introduire toutes les modifications de détail que l'on jugera opportunes, pourvu que cela n'altère pas l'essence du présent brevet additionnel, qui se trouve résumée dans les revendications suivantes.

## Revendications

1. "AMELIORATIONS INTRODUITES DANS LE PROCEDE DE FABRICATION DE CIRCUITS IMPRIMES OBJET DU BREVET PRINCIPAL Nº 9700184 (8) PAR UN PROCEDE DE FABRICATION DE CIRCUITS IMPRIMES", de ceux qui comprennent les opérations de préparation d'une feuille de cuivre (10), avec base supérieure (11) et base inférieure (12) et un usinage postérieur de (11) à l'aide d'une coupe ou d'un fraisage chimiques jusqu'à la création de sillons (13), puis, le remplissage de ceux-ci au moyen d'une substance de nature diélectrique, en procédant ensuite à une seconde coupe ou un second fraisage chimiques sur la base (12), pour finalement, en cas de circuits imprimés à double face, procéder au collage des supports diélectriques (14) par les moyens adéquats; caractérisées par le fait que les deux feuilles de cuivre (10) une fois usinées sur l'une de leurs faces (11) au moyen de coupe ou de fraisage chimiques, jusqu'à la création de sillons (13), sont immobilisés, en disposant les bases (12) de façon parallèle et en laissant entre elles un écartement qui sera rempli à l'aide d'un moulage ou d'injection ou de toute autre opération similaire.
